# EUROPEAN PATENT APPLICATION

(11) **EP 3 820 008 A1**
(43) Date of publication of application: **12.05.2021**
(21) Application number: 20205309.6
(22) Date of filing: 02.11.2020
(51) Int. Cl.: H02H 7/26

(54) **METHOD AND SYSTEM FOR LOCATING FAILURES IN A MEDIUM VOLTAGE POWER GRID**

(30) Priority: 05.11.2019 PL 43172119
(71) Applicant: PGE Dystrybucja S.A., 20-340 Lublin (PL); Mindmade Sp. z o.o., 00-647 Warszawa (PL); Apator Elkomtech S.A., 93-569 Lodz (PL)
(72) Inventor: MROCZEK, Bartlomiej, 20-488 lUBLIN (PL); BORKOWSKI, Tomasz, 02-758 Warszawa (PL); STEPNIEWICZ, Piotr, 05-500 Nowa Iwiczna (PL); BORKOWSKI, Marek, 92-701 Lodz (PL)
(74) Representative: Kalita, Lucjan

(57) **Abstract**

Method of a failure localization and its effects reduction in MV medium voltage power grid supplied from an energy source, creating a system having energy poles and switching points equipped in a connector with a drive for disconnecting/connecting the current flow and telemechanics devices, short-circuit current flow indicator, communication and other relies on that each telemechanics controller (Sᵢ) equipped in an indicator (W) of a short-circuit current flow and each communication device (Rᵢ) has the data assigned about it localization in MV grid in relation to the rest of telemechanics controllers (S₁ ÷ Sₙ) and communication devices (R₁ ÷ Rₙ) and programmed this way devices (S₁ ÷ Sₙ, R₁ ÷ Rₙ) are mounted in proper switching points (P₁ ÷ Pₙ). After detecting the short-circuit current flow by the indicators (W) and performing the AR automatic reclosing stage each telemechanics controller (Sᵢ) is communicating with respective two directly preceding telemechanics controllers (Sᵢ₋₁, Sᵢ₋₂) by assigning them the communication device (Rᵢ, Rᵢ₋₁, Rᵢ₋₂) and passing the information of the following content: "went through failure". After establishing a section (10) of MV grid between initial (Pₖ) and following it (Pₖ₊₁) switching points, for which the information from the initial telemechanics controller (Sₖ) has the following content: "went through failure" and simultaneously the same initial telemechanics controller (Sₖ) is not receiving the message from the following telemechanics controller (Sₖ₊₁) of following content: "went through failure", the closing of the power supply occurs by the connector (2) in the initial switching point (Pₖ) until the last switching point (Pₙ). For communication between the telemechanics controllers (S₁ ÷ Sₙ) the LoRa data transmission technology is used preferably with use of the range redundancy. The system for the method realization is also the subject matter of the invention.

## Description

The subject matter of the invention is a method for a failure localization and its effects reduction in a medium voltage (MV) power grid which thanks to a fast failure localization in a grid allows for a significant reduction of its effects. The realization of the method of a failure localization and its effects reduction together with an infrastructure of a medium voltage power grid as well as all necessary devices create a system, which also is the subject of the invention. The method and system devices are intended for a medium voltage power distribution grids, which in its nature do not work in the ring system of the power grid. Such grid consists of a core and branches of MV line, supplied from a separate line bays of 110kV/MV stations of a main power supply point (MPSP) or a grid switching stations (GSS).

Currently in case of the MV distribution grid damage the short-circuit, earth or phase balance current flow occurs, which is detected by a protection automatics for electrical power engineering - which leads to disconnecting of the entire damaged line. Usually after such disconnection the automatic reclosing (AR) automatics is activated in order to supply the voltage and check if the short-circuit was not transient one. If after one or two automatic reclosing the short-circuit current flow is still present then the definite line disconnection occurs.

The next stage after the definitive disconnection is the localization of damaged MV grid section. This is performed by disconnecting the line fragments by opening connectors in the core or branches and supplying the voltage to the line by closing the switch on the linear bay in MPSP. Usually after a few attempts combined with interpretation of the signals from automated protection systems equipment it is possible to locate and disconnect the line fragment from the connector preceding the damage until the line end.

Manipulating with connectors can be performed manually by electricians, which must drive to the damage place, or with use of electrical drives, controlled remotely by a dispatcher, e.g. by radio, with use of telemechanics controllers installed deep in the grid.

However, such method of localization is time consuming. The average time of localization with use of electrical emergency teams exceeds one hour and is causing multiplied power supply failures in a large number of the energy consumers - all supplied from the damaged line.

To shorten the localization time and restrict a failure affected range deeply in the MV grid the devices are installed equipped in automated protection systems, such as: automatic switches - reclosers or disconnectors equipped in short-circuits currents detection modules. However, the number of such devices in a single line sequence is strongly restricted and their cooperation relies on the time synchronization only. The switch in the linear bay in MPSP and reclosers have the time delay defined counted from the detection moment of the short-circuit current flow therefore adding another recloser in the line sequence is forcing MPSP disconnector delay increase which is very harmful in case of close damages occurrence. Namely is endangering the equipment for a flow of a big short-circuit currents for a long time which is rising together with the reclosers number mounted on the line sequence and on the section between MPSP and the first recloser especially. Therefore, in practice in a long MV line the number of reclosers is restricted to 2 -3 pieces maximally.

Repair actions are undertaken after localizing the damaged section, which depending on the damage type, can last from several hours to several days. Usually in order to restore the power supply as soon as possible to the biggest number of consumers it is necessary to reconfigure the grid. This is realized by manipulating with the connectors mounted deeply in the grid i.e. opening the first connector after the damaged place, closing the connectors in the cutout points and emergency power supply of the grid fragment e.g. from the neighboring line. Depending on the grid fill with remotely controlled switching devices the manipulation can be realized manually - orders issued by a dispatcher to electrical emergency teams - or remotely - control commands sent with SCADA (Supervisory Control and Data Acquisition) system - central element of the control and supervision system responsible for the data collection and archiving and allowing for the remote control execution. Known are solutions in which the reconfiguration is automated and realized with use of FDIR software (Fault Detection, Isolation and Restoration) integrated with SCADA system realizing the detection algorithms, short circuits isolation and automatic reconfiguration in MV and LV grids. FDIR system ensures localization of the failure places in the MV grid, elimination of the grid sections by their disconnecting with use of remotely controlled switching devices and the grid reconfiguration in order to restore the power supply for the biggest number of consumers deprived of the power supply as a result of a failure.

Patent publication PL 175293 discloses the method of short-circuits localization in a medium voltage power lines in which the information from the sensors about the power line condition is transmitted by a radio and along the core of medium voltage power line and in this line branches a groups of sensors are placed. With use of the sensors group the signal is achieved corresponding to the short-circuit condition on this line section after deducting by the controller corresponding to a given sensors group the full cycle of automatic activation of the line reconnection and stating by this controller the lack of voltage presence in this line section. Simultaneously the controller registers the short-circuit state and its type. Then this information is stored in this controller until the moment of its remote reading through the radio link by this line dispatcher.

The basic disadvantage of known solutions is this that the equipment of each automatics operates autonomously, and the only way to achieve selective disconnections is the time synchronization. In case of detecting a short circuit current the equipment localized the furthers from MPSP operates immediately, closer has set a few seconds delay, the longest delay has the switch in the linear bay in MPSP. Such situation is very inconvenient - close short-circuits, and thus characterized with the highest short-circuit currents, are sustained the longest and should be disconnected very fast. Moreover, on the localization stage the multiple short-circuit operating occurs which leads to an excessive switching devices wear. In case of the grid reconfiguration, with the power supply from the other line, it is necessary to manually change the settings of devices installed deeply in the grid, i.e. changing times and directionality of protections.

As shown above, independently from currently applied solutions, the whole process from the moment of a failure occurrence until its localization and restoring the power supply in the grid section not covered with the failure is time consuming, and actions complication level and time elongation builds up in case of the mass failures which influence very badly SAIDI *(System Average Interruption Duration Index)* reliability index *and SAIFI (System Average Interruption Frequency Index).*

Commercially available controllers (e.g. microBEL_SRS, by Apator Elkomtech) intended for MV air switching points are equipped in measuring systems allowing for the phase voltage and current measurement. According to the manufacturer information the controller basing on measurements is realizing functions of detecting earth and line-to-line short-circuits in grids of any work method of the neutral point. Those controllers are integrating functions of the short-circuits indicator and telemechanics controller. The software configuration of controllers covers a series of protection criteria, e.g.: overcurrent, earth fault, admittance, directional earth fault, allowing for detection of short-circuits in MV grids which in consequence ensures proper FDIR (Fault Detection, Isolation and Restoration) type automatics operation. MicroBEL_SRS controllers are equipped in a few communication ports, so they can perform simultaneous communication with the supervision system utilizing, amongst others, TETRA, Trunking, NETMAN, GSM/3G radio network as well as Ethernet 100Base-Tx network.

Known LoRa (Long Range) data transmission technology being a long-range protocol and wireless communication system of a low power LoRa technology is characterized with low energy requirement of the device used for communication which allows for a very long operation time of the sensor on one battery. Moreover, it ensures a long range reaching several kilometers depending on the natural topography.

Known TETRA (Terrestrial Trunked Radio, former TransEuropean Trunked Radio) system created by European Telecommunication Standards Institute (ETSI), is an open standard of dispatcher's digital radiotelephones communication (trunking), created with the intention especially for public safety and rescue services.

Known 3GPP (3rd Generation Partnership Project), mobile networks technology is covering:
GSM (2G) and its expansions (known under name 2.5G) such as GPRS and EDGE,
- UMTS (3G) and related elements and the standard expansions (such as HSPA),
- LTE together with the later modifications and expansions of the standard such as LTE Advanced and LTE Advanced Pro (both fulfilling IMT-Advanced requirements, commonly known under name 4G),
- 5G, being ITU IMT-2020 requirements realization.

The purpose of the invention is to shorten to minimum the time from a failure occurrence moment until a moment of MV line section diagnosis on which the damage occurred. The purpose of the invention is also minimalization of a failure effects by automatic separation of the damaged section and restoring the power supply on the line fragment not covered by the damage. The invention task is to relieve a dispatcher which currently is obliged to perform several activities to localize the failure places and mitigate its effects.

The essence of a failure localization method and its effects reduction in MV medium voltage grid supplied from a power source, creating a system having electricity poles and switching points equipped with a drive for disconnecting/connecting a current flow and telemechanics devices, short-circuit current flow indicator, connection devices and power supply equipment for supplying own requirements and other known devices and which method after detecting the short-circuit current flow covers the entire damaged line disconnection stage and then activation of automatic reclosing automatics to check if the short-circuit was not a transient one and the information about the failure occurrence is passing to the central element of SCADA control and supervision system **is this,** that each telemechanics controller equipped in the short-circuit current flow indicator and each communication device has the data assigned about its localization in MV grid in relation to other telemechanics controllers and communication devices and programmed this way devices are mounted in proper switching points. After detecting by the indicators, the short-circuit current flow and after performing the first disconnection in the AR cycle each telemechanics controller communicates with respective two directly preceding telemechanics controllers, as long as such exist. The communication occurs in the opposite direction to the current flow, towards the power supply source direction by assigning them the communication device and is passing the information of the following content: "went through failure". After establishing the MV grid section between initial and following it switching points, counting from the power source side, for which the information from the initial telemechanics controller has the following content: "went through failure" and simultaneously the same initial telemechanics controller is not receiving the information from the following telemechanics controller of following content: "went through failure", the power supply is disconnected by the connector for opening/closing the current flow in the initial switching point. Located this way MV grid section is the section in which the failure occurred. The fragment of MV grid line is disconnected until the last switching point. For communication between the telemechanics controllers the LoRa data transmission technology is used.

Preferably the transmission in LoRa technology is used with use of the range redundancy. The signal is transmitted by the router with LoRa modem included in the communication devices, then amplified and elongated by repeaters installed on energy poles between switching points. But to the central element of SCADA control and supervision system the information about the section in which the failure occurred is passed.

Preferably for communication additionally 3GPP data transmission technology or TETRA radio trunking systems are used.

The essence of the system for MV medium voltage power grid for a failure localization and its effects reduction in which power grid is supplied from the power supply source, has energy poles and switching points equipped in connectors with a drive for disconnecting/connecting the current flow and telemechanics devices, short-circuit current flow indicator, communication devices and own requirements power supply equipment and other known devices, communicated with the central element of SCADA control and supervision system, **relies on that** each telemechanics controller equipped in a short-circuit current flow indicator and each communication device has the data assigned about its localization in MV grid topology in relation to the rest of telemechanics controllers and communication devices, and programmed this way equipment is mounted in respective switching points. The communication devices cover the router with LoRa data transmission modem. On poles between switching points the LoRa network signal amplifying and extending repeaters are installed. Each repeater located on MV line sequence is in communication range with at least two preceding and following repeaters. Configured this way repeaters, together with communication devices in a form of routers with LoRa modems are realizing the range redundancy. Thanks to this the communication system is adopted to the operation time requirements and ensures increased message delivery certainty.

Preferably the router of communication devices is equipped in 3GPP data transmission or TETRA trunking radio systems modem.

The method and system for MV grid according to current invention allows to change current grid supervision and management methods. The system for the grid of indicated structure and implemented failure localization method relay on the direct communication of telemechanics controllers between each other is thus proposing decentralization of damage recognition elements, making the decision and automatic disconnecting of the damaged section. This way the diagnosis and separation of the damaged grid section process itself is accelerated. Its isolation will occur in 21 seconds maximally from the first line disconnection in MPSP during the second voltage-free break in AR cycle. Thereby the power supply restoration in the part of the line from the power supply source to the isolation point will occur in 21 seconds from the first disconnection. In systems used by now such result was not achieved.

Moreover, the place, in which the failure occurred, localization precision is increased, namely it is known on which section the damage occurred, there is no need to examine the entire disconnected line. This was achieved also by increasing deeply in MV line the number of switching points equipped in directional short-circuit current flow indicators.

Thanks to the invention the grid dispatcher will be relieved and the decision process will be accelerated. In this case the dispatcher through the central element of SCADA control and supervision system will receive the information about:
- damage in the specific grid section, restricted with switching points, equipped in a short-circuit current indicators,
- separation of the damaged grid section,
- the power restoration in the area not covered by the failure.

Basing on this the dispatcher will be able to send electrical emergency teams to the precisely specified area and significantly accelerate repair of damaged grid section. Previously the dispatcher had to perform "manually" the entire damage and power restoration process in the section not covered by the failure.

Thanks to possession by the telemechanics controllers and thus short-circuit current flow indicators the "consciousness" of the localization in MV grid topology, after disconnecting the line they autonomically establish the section in which there is a failure. Establishing the failure place takes place without initializing communication with SCADA system, so it is independent from it.

Use of the communication in LoRa technology as a basic data transmission system between switching points allows to achieve the time regimes in communication between switching points below 2.5 second, which is necessary for uninterrupted operation of MPSP connection cycle. Built data transmission network in LoRa area is based on the range redundancy. As a supplementary and backup communication the 3GPP mobile networks or Tetra networks technology are used. Thanks to this the system is resistant to a damage of individual or several transmission network devices in one sequence. The additional attribute of LoRa dedicated network use is this that it is built with use of repeaters sequence installed directly on the infrastructure - energy poles of MV grid. Thanks to this you can avoid additional costs related with building base stations, power connections, etc.

Using dedicated LoRa network and use of 3GPP mobile networks technology or TETRA networks only as a backup or supplementation is a result of the fact that mobile networks or TETRA networks do not ensure:
- Proper time regimes of a message sending (data transmission) between switching points.
- Covering with its range all areas of the energy grids infrastructure presence. The fact of the range lack in places of an energy infrastructure presence is commonly known. Mobile networks are set for covering with its range populated areas but not e.g. forests areas, and as known there is an energy grid infrastructure there as well.
- Proper SLA (Service Level Agreement) protection in case of the base stations damage. In case of the base station damage very large area stays without range.
- Proper safety of tele informatics of transferred information. In case of mobile networks, the data are transferred through public networks, and consequence transferred data are not properly protected.

Described method of the system operation is carried out without necessity to contact with SCADA system, which may be difficult, and the information transfer time in case of mass failures extended. Establishing the failure place will take place without initiating the communication with SCADA system, to which only the final information about the failure, its place and disconnecting damaged fragment of MV grid will arrive.

The invention subject is pictured on the embodiment and on the figure on which:

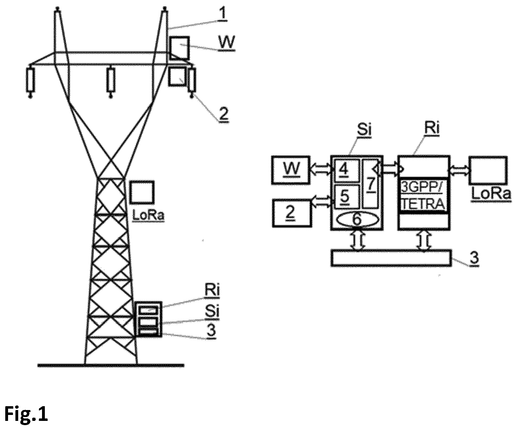

Fig. 1 shows a switching point equipment diagram for a medium voltage energy grid;

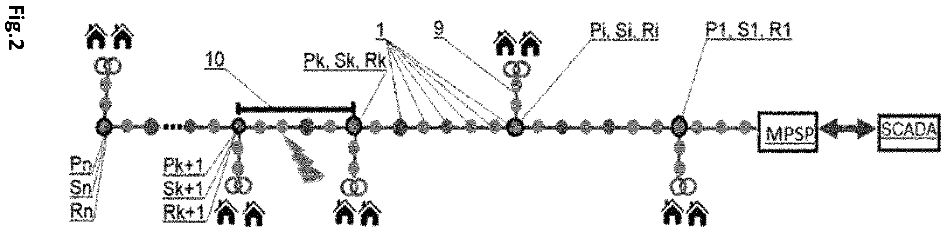

Fig. 2 shows schematically the rule of the system operation for MV grid;

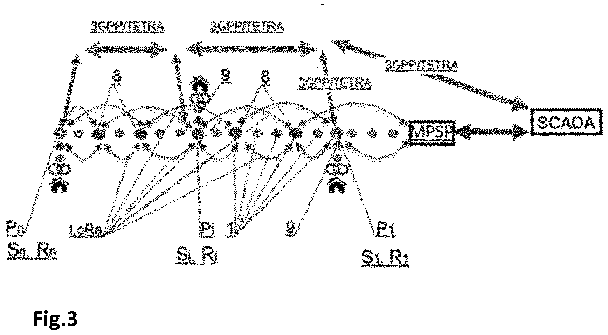

Fig. 3 shows schematically the communication method in the system for MV grid.

A system for a medium voltage energy grid for a failure localization and its effects reduction supplied from MPSP main power supply point, has energy poles 1 part of which have switching points P₁ ÷ Pₙ,
where *n*- number of switching points,
which are equipped in connectors 2 with a drive for disconnecting/connecting the current flow. In switching points P₁ ÷ Pₙ there are telemechanics devices mounted with a measuring system and indicator W of the short-circuit current flow, communication devices R₁ ÷ Rₙ in form of a router and own requirements power supply 3 and other known devices such as: circuit breakers, heater, ventilator, temperature probe, hygrostat. Telemechanics devices are communicated with the central element of SCADA control and supervision system through communication devices R₁ ÷ Rₙ. Each telemechanics controller Sᵢ equipped in a measuring system with an indicator W of short-circuit current flow and each communication device Rᵢ in form of a router has the data assigned about its localization in MV grid topology in relation to the rest of telemechanics controllers S₁ ÷ Sₙ and communication devices R₁ ÷ Rₙ. Programmed this way devices S₁ ÷ Sₙ, R₁ ÷ Rₙ are mounted in respective switching points P₁ ÷ Pₙ. The measuring system with the indicator W of the short-circuit current flow is connected with the measuring module 4 of the telemechanics controller Sᵢ. Moreover, each telemechanics controller Sᵢ has a control module 5 which controls disconnection execution elements, including a connector 2, as well as a signalization module 6 and a communication module 7 for communication with a communication device Rᵢ. Each communication device Rᵢ in a form of a router has LoRa modem, 3GPP modem or an interface for TETRA modem. On energy poles 1 between switching points P₁ ÷ Pₙ repeaters 8 are installed which task is to amplify a signal and extend LoRa network range.

Method of a failure localization and its effects reduction in MV medium voltage power grid supplied from MPSP main power supply point for which the system is built as above relies according to this invention on that each telemechanics controller Sᵢ equipped in the measuring system with the indicator W of the short-circuit current flow and each communication device Rᵢ has the data assigned about its localization in MV grid topology in relation to the rest of the telemechanics controllers S₁ ÷ Sₙ and communication devices R₁ ÷ Rₙ and programed this way devices S₁ ÷ Sₙ, R₁ ÷ Rₙ are mounted in respective switching points P₁ ÷ Pₙ. In case of detecting the short-circuit current flow the entire damaged line is disconnected. Then the automatics of AR automatic reclosing is activated in order to check if the short-circuit was not a transient one. If after AR automatic reclosing the short-circuit current flow is still present then it is detected by Sᵢ controller equipped in the short-circuit current flow indicator W. Then each telemechanics controller Sᵢ communicates in this example with respective two directly preceding telemechanics controllers: Sᵢ₋₂, Sᵢ₋₁, by assigning them the communication device Rᵢ, Rᵢ₋₁, Rᵢ₋₂ and passing the information of the following content: "went through failure". It is obvious that the first telemechanics controller S₁, mounted in the first switching point P₁, as the preceding switching points do not exist for it, is programmed this way that it does not have to communicate with preceding devices. After establishing the section 10 of MV grid between initial Pₖ and following it Pₖ₊₁ switching points, for which the information from the initial telemechanics controller Sₖ has the following content: "went through failure" and simultaneously the initial telemechanics controller Sₖ is not receiving from the following telemechanics controller Sₖ₊₁ the message of the content "went through failure", the power supply is disconnected by the connector 2 in the initial switching point Pₖ, behind which section 10 is located on which the failure occurred. Then the power supply disconnection occurs on MV line fragment from the initial switching point Pₖ until the last switching point Pₙ of MV grid line. To the central element of SCADA control and supervision system the information about the section 10 in which the failure occurred is passed. For communication between telemechanics controllers S₁ ÷ Sₙ the LoRa data transmission technology is used. As a supplementary or backup, the 3GPP or Tetra data transmission technology is used. To increase the range and achieve a better reliability of LoRa network (the range redundancy) the repeaters 8 are used, installed on the energy poles 1 between switching points P₁ ÷ Pₙ. In a difficult terrain the repeaters 8 are apart from each other on average 1 km.

## Claims

1. Method of a failure localization and its effects reduction in MV medium voltage power grid supplied from a power source, creating a system having energy poles and switching points equipped in a connector with a drive for disconnecting/connecting a current flow and telemechanics devices, short-circuit current flow indicator, communication devices and own requirements power supply devices as well as other known devices and which method after detecting the short-circuit current flow covers the stage of disconnecting the entire damaged line and then activation of AR automatic reclosing automatics in order to check if the short-circuit was not a transient one and passing the information about the failure occurrence to the central element of SCADA control and supervision system, **characterized by that** each telemechanics controller (Sᵢ) equipped in an indicator (W) of a short-circuit current flow and each communication device (Rᵢ) has the data assigned about its localization in MV grid in relation to the rest of telemechanics controllers (S₁ ÷ Sₙ) and communication devices (R₁ ÷ Rₙ) and programed this way devices (S₁ ÷ Sₙ, R₁ ÷ Rₙ) are mounted in appropriate switching points (P₁ ÷ Pₙ) and after detecting the short-circuit current flow by the indicator (W) and performing AR automatic reclosing stage each telemechanics controller (Sᵢ) is communicating with respective two directly preceding telemechnics controllers (Sᵢ₋₁, Sᵢ₋₂), as long as such ones exist, by assigning them the communication device (Rᵢ, Rᵢ₋₁, Rᵢ₋₂) and passing the information of the following content: "went through failure", and after establishing a section (10) of MV grid between initial (Pₖ) and following it (Pₖ₊₁) switching points, for which the information from the initial telemechanics controller (Sₖ) has the following content: "went through failure" and simultaneously the same initial telemechanics controller (Sₖ) is not receiving the message from the following telemechanics controller (Sₖ+1) of the following content: "went through failure", followed by disconnecting the power supply by the connector (2) for opening/closing the current flow in the initial switching point (Pₖ), behind which the section (10) is located, in which the failure occurred, to the last switching point (Pₙ) of MV grid line whereby for communication between telemechnics controllers (S₁ ÷ Sₙ) the LoRa data transmission technology is used.

2. Method according to the claim 1, **characterized by that** transmission in LoRa technology is used with use of a range redundancy where a signal is transmitted by a router, being the part of communication devices (R₁ ÷ Rₙ), with LoRa modem and amplified and extended by repeaters (8) installed on energy poles (1) between switching points (P₁ ÷ Pₙ), but to the central element of SCADA control and supervision system the information about a section (10) is passed in which a failure occurred.

3. Method according to the claim **characterized by that** for communication additionally 3GPP data transmission technology or TETRA radio trunking systems are used.

4. The system for MV medium voltage energy grid for a failure localization and its effects reduction in which MV energy grid is supplied from the power source, has energy poles and switching points equipped in a connector with a drive for disconnecting/connecting the current flow and telemechanics devices, short-circuit current flow indicator, communication devices and own requirements power supply devices as well as other known devices, communicated with the central element of SCADA control and supervision system **characterized by that** each telemechanics controller (Sₖ) equipped in the short-circuit current flow indicator (W) and each communication device (Rₖ) has the data assigned about it localization in MV grid topology in relation to the rest of the telemechanics controllers (S₁ ÷ Sₙ) and communication devices (R₁ ÷ Rₙ), and programmed this way devices (S₁ ÷ Sₙ, R₁ ÷ Rₙ) are mounted in respective switching points (P₁ ÷ Pₙ), whereby the communication devices (R₁ ÷ Rₙ) include the router with LoRa data transmission modem, and on the energy poles (1) between the switching points (P₁ ÷ Pₙ) the repeaters (8) are installed amplifying the signal transmitted by LoRa data transmission.

5. The system according to the claim 4, **characterized by that** the router of the communication devices (R₁ ÷ Rₙ) is equipped in 3GPP data transmission or radio trunking system (TETRA) modem.
